(19)

Europäisches
Patentamt
European
Patent Office
Office européen
des brevets

(11) **EP 1 783 825 A1**

(12) **EUROPEAN PATENT APPLICATION**
published in accordance with Art. 158(3) EPC

(43) Date of publication:
**09.05.2007 Bulletin 2007/19**

(21) Application number: **05758208.2**

(22) Date of filing: **06.07.2005**

(51) Int Cl.:
*H01L 21/3065* (2006.01)   *C30B 29/36* (2006.01)
*C30B 33/08* (2006.01)

(86) International application number:
**PCT/JP2005/012473**

(87) International publication number:
**WO 2006/006466 (19.01.2006 Gazette 2006/03)**

(84) Designated Contracting States:
**DE FR GB SE**

(30) Priority: **08.07.2004 JP 2004201617**

(71) Applicants:
 • **TOYO TANSO CO., LTD.**
  **Osaka-shi,**
  **Osaka 555-0011 (JP)**
 • **MITSUI TAKEDA CHEMICALS, INC.**
  **Tokyo 105-7117 (JP)**
 • **SUMITOMO OSAKA CEMENT CO., LTD.**
  **Tokyo 102-8465 (JP)**

(72) Inventors:
 • **TASAKA, Akimasa**
  **Kyoto-shi,**
  **Kyoto 610-1125 (JP)**

 • **TOJO, Tetsuro,**
  **c/o TOYO TANSO CO., LTD.**
  **Osaka-shi,**
  **Osaka 555-0011 (JP)**
 • **INABA, Minoru,**
  **Rusheru-Nishinokyo-Oike 1101**
  **Kyoto-shi,**
  **Kyoto 604-8444 (JP)**
 • **MIMOTO, Atsuhisa,**
  **c/o Mitsui Chemicals, Inc.**
  **Tokyo 105-71 17 (JP)**
 • **TANAKA, Masamichi,**
  **Sumitomo Osaka Cement Co., Ltd**
  **Tokyo 102-8465 (JP)**
 • **SHIMA, Kaori,**
  **Sumitomo Osaka Cement Co., Ltd**
  **Tokyo 102-8465 (JP)**

(74) Representative: **TBK-Patent**
  **Bavariaring 4-6**
  **80336 München (DE)**

(54) **SILICON CARBIDE SINGLE CRYSTAL AND METHOD OF ETCHING THE SAME**

(57)    Single-crystal silicon carbide is obtained, which finds a wide variety of applications including semiconductors, and an etchingmethod for single-crystal silicon carbide is provided, by which nitrogen trifluoride plasma is used in single-crystal silicon carbide to obtain a smooth surface.

In order to obtain single-crystal silicon carbide having the smoothness (surface roughness) within $\pm 150$nm and the material, nitrogen trifluoride-containing gas is subjected to plasma excitation to obtain single-crystal silicon carbide with a smooth surface . It is preferable that the pressure of nitrogen trifluoride gas is in the range of 0.5 to 10Pa. It is also preferable that the flow rate of the nitrogen trifluoride gas is in the range of 5 to 15sccm.

FIG. 1

EP 1 783 825 A1

**Description**

Technical Field

The present invention relates to single-crystal silicon carbide and the etching method thereof and, more particularly, relates to an etching method for single-crystal silicon carbide by which nitrogen trifluoride is brought into contact with single-crystal silicon carbide.

Background Art

Our daily lives are increasingly dependent on electric energy and demand for electric power is expected to grow over the long term. Under these circumstances, it is particularly important to save conversion loss of electric power in electric energy systems. It has already been found that silicon semiconductors most commonly used in currently existing semiconductor electronics are theoretically limited in terms of physical properties. There are problems that no further reduction in the conversion loss of electric power or the operation of device at a higher speed, at a higher temperature or with high pressure resistivity can be expected. As such, silicon carbide has become the focus of attention as a semiconductor material for the next generation.

Silicon carbide is characterized by a wide band gap, high-thermal conductivity, low-thermal expansion ratio, etc., and expected to find applications such as high-power/high-frequency devices and power devices as a semiconductor material, because of the physical properties which are not achieved by silicon. It is, however, extremely difficult to provide high-precision processing to silicon carbide due to its great thermal and chemical stability. Chemical etching treatment of silicon carbide requires high temperatures from 600 to 800˚C and also tends to form an isotropic cross section. In contrast, dry etching treatment such as reactive ion etching is able to simultaneously provide physical etching by cations present inside plasma and chemical etching by radicals, thereby an anisotropic etching high in the selectivity is provided and productivity is also improved. At the present time when semiconductor devices are available at a higher density and a greater integration, more elaborate high-precision pattern processing is demanded. Under these circumstances, silicon carbide is required to have a surface smoothness after etching treatment. It is noted that the above-described reactive ion etching is mainly used as an etching method in semiconductor industries. The following Non-patent Documents are referred to as documents covering research on the above-described dry etching of silicon carbide by plasma in which fluorine-based gas is used.

[Non-patent Document 1] P.H.YihA. J. Steckel, J. Electrochem. Soc., 140, 1813 (1993)
[Non-patent Document 2] J. Sugiura, W. J. Lu, K. C. Cadien, and A. J. Steckel, J. Vac. Sci. Technol., B4, 349 (1986)
[Non-patent Document 3] J. W. Palmour, R. F. Davis, T. M. Wallet, and K. B. Bhasm, J. Vac. Sci. Technol., A4, 590 (1986)
[Non-patent Document 4] G. Kelner, S. C. Binari, and P. H. Klein, J. Electrochem. Soc., 137, 213 (1990)
[Non-patent Document 5] J. W. Palmour, R. F. Davis, P. Astell-Burt, and P. Blackborow, Mater. Res. Soc. Symp. Proc., 76, 185 (1987)
[Non-patent Document 6] W.-S. Pan and A. J. Steckel, J. Electrochem. Soc., 137 213 (1990)
[Non-patent Document 7] R. Padiyath, R. L. Wright, M. I. Caudhry, and S. V. Babu, Appl. Phys. Lett., 58, 1053 (1991)
[Non-patent Document 8] Wang J. J., Lambers E. S., Pearton S. J., Ostling M. , Zetterling C. M., Grow J. M., Ren F., and Shul R. J., Vac. Sci. Technol., A16, 2204 (1198)
[Non-patent Document 9] G. Kelner, S. C. Binari, and P. H. Klen, J. Electrochem. Soc., 134, 253 (1987)

Disclosure of the Invention

Problems to be Solved by the Invention

In general, where plasma of fluorine-containing gas such as nitrogen trifluoride gas is brought into contact with silicon carbide, it is known that, depending on how to allow the fluorine-containing gas to contact with plasma, irregularities called spikes are formed on the surface of single-crystal silicon carbide. Each of the above Non-patent Documents covers a description that etching can be performed on the surface of silicon carbide by changing a type of various fluorine-containing gases but does not disclose any means for providing a high-precision etching on the surface of the single-crystal silicon carbide concerned.

An object of the present invention is to provide a single-crystal silicon carbide excellent in smoothness and an etching method for single-crystal silicon carbide by which nitrogen trifluoride plasma are used to etch the surface of single-crystal silicon carbide at a high precision.

Means for Solving the Problem

In order to solve the above problem, the present inventors have evaluated in detail etching conditions which allow contact with the surface of single-crystal silicon carbide, and have found an etching method for single-crystal silicon carbide having a smooth surface and have completed the present invention.

According to the present invention, single-crystal silicon carbide is that having smoothness (surface roughness) within ±150nm on the basis of observation by an atomic force microscope.

Further, the present invention mainly deals with an etching method for single-crystal silicon carbide in which nitrogen trifluoride plasma is used to provide etching on the surface of single-crystal silicon carbide. Still further, the present invention mainly deals with an etching method for single-crystal silicon carbide in which a preferable pressure of nitrogen trifluoride gas is in the range of 0.5 to 10Pa. When the pressure of nitrogen trifluoride gas is lower than 0.5Pa, smoothness is not sufficiently provided on the surface of single-crystal silicon carbide. When the pressure of nitrogen trifluoride exceeds 10Pa, spikes will be formed on the surface of single-crystal silicon carbide, which is not preferable.

In addition, the present invention mainly deals with an etching method for single-crystal silicon carbide in which a preferable flow rate of nitrogen trifluoride gas is in the range of 5 to 15sccm (standard cc per minute). When the flow rate of nitrogen trifluoride is lower than 5sccm, as described above, the single-crystal silicon carbide will be etched at an extremely slow rate. In contrast, when the flow rate of nitrogen trifluoride exceeds 15sccm, spikes are formed on the surface of single-crystal silicon carbide, as described above, which is not preferable.

Further, the present invention mainly deals with an etching method for single-crystal silicon carbide in which RF power (reflected power: applied power) is preferably in the range of 50W to 100W. When the RF power is lower than 50W, the etching rate is reduced, which is not preferable. When the RF power exceeds 100W, the above etching is provided in a spike form, which is not preferable either. It is preferable that a reaction time is in the range of 4 to 15 minutes.

Still further, the present invention mainly deals with an etching method for single-crystal silicon carbide in which ion etching by rare gas radical and down-flow etching by nitrogen trifluoride gas is repeatedly performed to make the surface smooth.

In particular, it is preferable that an etched surface of single-crystal silicon carbide which is etched by plasma under the pressure of nitrogen trifluoride gas of 10Pa or more and given a spike form is subj ected to the treatment which repeats ion etching by rare gas radical and down-flow etching (hereinafter, referred to as DFE) by nitrogen trifluoride gas. In this instance, the DFE is defined as a process of performing etching, with the damage to samples resulting from plasma being reduced.

It is preferable that the pressure of argon gas in performing ion etching is in the range of 0.1 to 10Pa, the RF power is from 50 to 100W, and the reaction time is from 5 to 15 minutes.

Further, it is preferable that down-flow etching is performed under the pressure of nitrogen trifluoride gas in the range of 0.5 to 10Pa and the RF power is in the range of 50 to 100W. A preferable reaction time is in the range of 5 to 15 minutes. Still further, it is preferable to repeat ion etching and down-flow etching more than 40 times.

So-called nitrogen trifluoride mixed gas in which oxygen gas is mixed with the above-described nitrogen trifluoride gas is also allowed to act on single-crystal silicon carbide to etch single-crystal silicon carbide, thereby it makes it possible to further reduce spikes formed on the surface of single-crystal silicon carbide. The oxygen gas is preferably supplied at concentrations from 5 to 20% and more preferably from 10 to 20%.

After the above-described nitrogen trifluoride mixed gas is allowed to act on single-crystal silicon carbide to etch single-crystal silicon carbide, ion etching by rare gas radical and down-flow etching by nitrogen trifluoride gas may be repeated to obtain a smooth surface. It is preferable that the conditions of repeating the ion etching and the down-flow etching are the same as those described above.

The present invention also mainly deals with an etching method for single-crystal silicon carbide in which single-crystal silicon carbide is selected from a 3C type, 4H type and 6H type. Single-crystal silicon carbide itself is available in various types other than the above-described three types. It is, however, possible to perform an extremely smooth etching by using the single-crystal silicon carbide selected from these three types so as to attain the surface roughness of ±150nm or less after the surface treatment by nitrogen trifluoride. Single-crystal silicon carbide of the 4H type is wider in band gap, namely, 3. 2eV, and has less defects. This silicon carbide is highly expected to find an application as a power device to be used in an electric automobile, etc. , because it is now available in a larger diameter and at a high efficiency, in addition to the above-described excellent properties. Single-crystal silicon carbide of the 6H type is slow in electron mobility but similar to silicon carbide having the 4H type structure. Further, single-crystal silicon carbide of the 3C type is narrow in band gap, namely 2. 9V, and has high defects. However, since this silicon carbide can be manufactured at low temperatures and also made larger in diameter, it is highly expected to find applications such as a general inverter for which a cost benefit is demanded.

Effects of the Invention

In the present invention, single-crystal silicon carbide is used to perform etching treatment by using nitrogen trifluoride mixed gas containing nitrogen trifluoride or oxygen gas under optimal conditions, thereby it makes it possible to obtain single-crystal silicon carbide which is quite smooth on the surface. Further, where the pressure of nitrogen trifluoride is 10Pa or more under the above etching conditions, spikes are formed on the etched surface. In this instance as well, etching treatment by $Ar^+$ ion and down-flow etching by nitrogen trifluoride are alternately repeated several times, thereby the single-crystal silicon carbide with smoothness is obtained. It is further secured to find applications such as an electricity device and a power device due to availability of the above-described smoothness. Embodiments

Hereinafter, an explanation will be made for the present invention with reference to the embodiments. However, the present invention shall not be construed to be restricted to these embodiments.

(Preparation of samples of single-crystal silicon carbide and introduction into chamber)

4H-type single-crystal silicon carbide, 6H-type single-crystal silicon carbide and 3C-type single-crystal silicon carbide, each of which measures 7.0 x 5.0 x 1.0 (mm), are prepared and these samples are introduced into a plasma chamber.

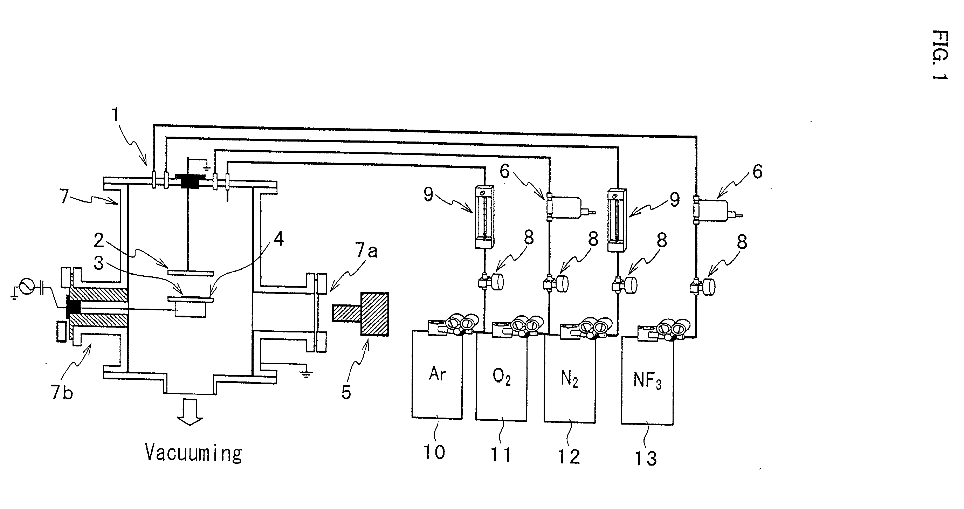

Figure 1 is a drawing briefly showing the plasma chamber used in experiments. Reference numeral 1 denotes a gas feeding port; 2 denotes a grounding electrode; 3 denotes a sample, 4 denotes an RF electrode; 5 denotes a CCD camera; 6 denotes a flow controller; 7 denotes a chamber body; 8 denotes a valve; 9 denotes a flow meter; and 10 to 13 respectively denote storage tanks of argon (Ar) gas, oxygen ($O_2$) gas, nitrogen ($N_2$) gas and nitrogen trifluoride ($NF_3$) gas. The chamber body 7 is made with stainless steel (SUS 304) and provided with a cylindrical window portion 7a projecting from the side surface of the chamber body 7. The window portion 7a is formed by fitting a transparent member such as glass into the outermost periphery so that the internal part can be observed by a CCD camera 5. Further, a tubal portion 7b into which an electric wiring for connecting the RF electrode 4 to a power source is inserted is provided on a side opposite the window portion 7a of the chamber body 7. In Figure 1, the grounding electrode is given on the upper side and the RF electrode is given on the lower side. However, in reality, these two electrodes can be freely interchanged.

When individual samples are placed on the RF electrode on a lower side to induce plasma, a space charge region which is called an ion sheath is formed around the RF electrode due to a difference in mobility between electrons and ions, thereby a region where electrolysis undergoes a substantially similar change is provided. When cations generated inside a plasma region are charged into an ion sheath region, ions are accelerated by a vertical electrical field generated in the region and allowed to enter in the vertical direction to the samples, thereby a physical collision is caused.

On the other hand, neutral molecules such as radicals in the plasma are allowed to enter, without having orientation, thereby a chemical reaction is caused. More specifically, it is possible to perform reactive ion etching having both characteristics of physical etching and chemical etching. The chamber is structured so as to effect discharge under vacuum from the lower part of the chamber by using a rotary pump and an oil diffusion pump, with the ultimate vacuum being $1.3 \times 10^3$ Pa. A liquid nitrogen trap is provided between the etching chamber and the oil diffusion pump, thereby it makes it possible to reduce a quantity of reactive gas dissociated during the etching which will flow into the oil diffusion pump or the rotary pump. It is, therefore, possible to effect discharge under vacuum until the pressure reaches a level of $1.33 \times 10^{-3}$ Pa and further discharge for 60 minutes continuously.

(Method for etching treatment)

After the discharge under vacuum, a needle valve (KOFLOC model RK-1200, made by Kojima Seisakusho Co., Ltd.) is used to adjust the pressure of nitrogen trifluoride (made by Mitsui Chemicals Inc.) to a predetermined level, which is then allowed to stand for 5 minutes. After the flow rate becomes stable, RF plasma having 13.56MHz is induced. Further, a matching unit MU-2 (made by SAMCO International Inc.) is also used to make adjustment so that the RF power can be minimized.

During the plasma induction, cooling water kept at a constant temperature is circulated through a sample base, by which the samples are kept at 50˚C. After completion of the etching, discharge under vacuum is effected again for approximately 10 minutes to remove activated species remaining inside the chamber, thereby reactions with the samples are prevented. Thereafter, in order to prevent the effect of adsorption of $H_2O$ and $O_2$ present in the air to the greatest possible extent, $N_2$ is introduced to a level of 1 atm and the samples are then removed from the chamber. Also in order to prevent the effect of the air, the thus removed samples are immediately placed into a vacuum desiccator containing drying agents and oxygen absorbing agents (ultimate vacuum of $1.33 \times 10^2$ Pa) and retained therein.

Further, the change in the etching rate resulting from the change in the types of samples (single-crystal silicon carbide substrate), the change in the flow rate of nitrogen trifluoride, pressure and appliedpower as well as the smoothness (surface roughness) of etched samples are measured by an atomic force microscope to provide embodiments 1 to 25 and comparative examples 1 to 7, the results of which are summarized in Table 1. In this instance, where the surface roughness of etched single-crystal silicon carbide is within ±150nm, the silicon carbide concerned is designated as o, and where the surface roughness is particularly within ± 50 nm, it is designated as ◎. In contrast, where the surface roughness is larger than ±150nm, it is designated as x. Further, oxygen gas is mixed with nitrogen trifluoride gas at a predetermined pressure to perform etching in such a way that the concentration of oxygen gas in the mixed gas can be 10% and 20% respectively in the embodiments 10 and 11, the results of which are shown in Table 1.

[Table 1]

| | Crystal structure of silicon carbide | Nitrogen trifluoride | | RF power (W) | Etched surface | | Reaction time (min) | Remarks |
|---|---|---|---|---|---|---|---|---|
| | | Pressure (Pa) | Flow rate (sccm) | | Smoothness note 1) | Etching rate (A/min.) | | |
| Embodiment 1 | 4H | 0.5 | 10 | 100 | ○ | 700 | 10 | - |
| Embodiment 2 | 4H | 1 | 10 | 100 | ○ | 650 | 10 | - |
| Embodiment 3 | 4H | 2 | 10 | 100 | ◎ | 550 | 10 | - |
| Embodiment 4 | 6H | 2 | 10 | 100 | ◎ | 630 | 10 | - |
| Embodiment 5 | 3C | 2 | 10 | 100 | ◎ | 620 | 10 | - |
| Embodiment 6 | 4H | 10 | 10 | 100 | ○ | 500 | 10 | - |
| Embodiment 7 | 4H | 2 | 15 | 100 | ○ | 600 | 10 | - |
| Embodiment 8 | 4H | 2 | 10 | 75 | ◎ | 500 | 10 | - |
| Embodiment 9 | 4H | 2 | 5 | 100 | ◎ | 550 | 10 | - |
| Embodiment 10 | 4H | 0.5 | 10 | 100 | ○ | 800 | 10 | Oxygen concentra |
| Embodiment 11 | 4H | 0.5 | 10 | 100 | ○ | 750 | 10 | Oxygen concentra |
| Embodiment 12 | 6H | 2 | 10 | 100 | ◎ | 750 | 10 | Oxygen concentra |
| Embodiment 13 | 6H | 2 | 10 | 100 | ◎ | 700 | 10 | Oxygen concentra |
| Embodiment 14 | 3C | 3 | 10 | 100 | ◎ | 700 | 10 | Oxygen concentra |
| Embodiment 15 | 3C | 3 | 10 | 100 | ◎ | 730 | 10 | Oxygen concentra |
| Embodiment 16 | 6H | 0.5 | 10 | 100 | ○ | 650 | 10 | - |

(continued)

| | Crystal structure of silicon carbide | Nitrogen trifluoride | | RF power (W) | Etched surface | | Reaction time (min) | Remarks |
|---|---|---|---|---|---|---|---|---|
| | | Press ure | Flow rate | | Smoothness note 1) | Etching rate (A/min.) | | |
| | | (Pa) | (scc m) | | | | | |
| Embodiment 17 | 6H | 10 | 15 | 100 | ○ | 600 | 10 | - |
| Embodiment 18 | 6H | 2 | 5 | 100 | ○ | 560 | 10 | - |
| Embodiment 19 | 6H | 0.5 | 10 | 60 | ○ | 550 | 10 | - |
| Embodiment 20 | 6H | 0.5 | 10 | 80 | ○ | 600 | 10 | - |
| Embodiment 21 | 3C | 0.5 | 10 | 100 | ○ | 650 | 10 | - |
| Embodiment 22 | 3C | 10 | 10 | 100 | ○ | 600 | 10 | - |
| Embodiment 23 | 3C | 2 | 5 | 100 | ○ | 600 | 10 | - |
| Embodiment 24 | 3C | 2 | 10 | 80 | ◎ | 650 | 10 | - |
| Embodiment 25 | 3C | 2 | 15 | 100 | ○ | 600 | 10 | - |
| Comparative example 1 | 4H | 2 | 10 | 40 | × | 300 | 10 | - |
| Comparative example 2 | 4H | 2 | 10 | 130 | × | 600 | 10 | - |
| Comparative example 3 | 4H | 10 | 10 | 120 | × | 500 | 10 | - |
| Comparative example 4 | 4H | 20 | 10 | 100 | × | 600 | 10 | - |
| Comparative example 5 | 4H | 2 | 20 | 100 | × | 600 | 10 | - |
| Comparative example 6 | 4H | 2 | 3 | 100 | ○ | 450 | 10 | - |

EP 1 783 825 A1

(continued)

| | Crystal structure of silicon carbide | Nitrogen trifluoride | | RF power (W) | Etched surface | | Reaction time (min) | Remarks |
|---|---|---|---|---|---|---|---|---|
| | | Pressure (Pa) | Flow rate (sccm) | | Smoothness note 1) | Etching rate (A/min.) | | |
| Comparative example 7 | 4H | 0.1 | 10 | 100 | ○ | 400 | 10 | - |
| Note 1): smoothness: ◎ within ±50nm, o larger than 50nm but 150nm or less, × larger than ±150nm | | | | | | | | |

Further, in order to conduct comparative experiments, 4H-type single-crystal silicon carbide is used to perform etching treatment by allowing the conditions to change within a scope under the etching conditions of the present invention. Still further, evaluation is made for further smoothness of the surface of single-crystal silicon carbide given in a spike form (measured by an atomic force microscope). More specifically, prior to introduction of nitrogen trifluoride, sputtering treatment is performed in advance on the surface of single-crystal silicon carbide only by using $Ar^+$ ion (one type of rare gases) at 3Pa, and DFE treatment is then performed by using nitrogen trifluoride. A two-stage treatment made up of sputtering by $Ar^+$ ions and a subsequent treatment by fluorine radicals (fluorine radicals generated by DFE) is repeated. The number of such repetitions and the smoothness of single-crystal silicon carbide samples are evaluated in the embodiments 26 to 28, the comparative example 8 and the comparative example 9, the results of which are summarized in Table 2.

[Table 2]

| | Crystal structure of silicon carbide obtained through reaction with nitrogen trifluoride alone | Down-flow etching (DFE) (a) | | Etching by Ar$^+$ ions (b) | | Repetition number of (a) and (b) | Smoothness note 2) |
|---|---|---|---|---|---|---|---|
| | | Nitrogen trifluoride Pressure (Pa) | RF power (W) | Pressure (Pa) | RF power (W) | | |
| Embodiment 26 | 4H | 53 | 100 | 3 | 150 | 40 | ◎ |
| Embodiment 27 | 6H | 53 | 100 | 3 | 150 | 40 | ◎ |
| Embodiment 28 | 3C | 53 | 100 | 3 | 150 | 40 | ◎ |
| Comparative example 8 | 4H | 53 | 100 | 3 | 150 | 35 | × |
| Comparative example 9 | 4H | 53 | 100 | 3 | 150 | 25 | × |
| Note 2): smoothness: ◎ within ±50nm, o larger than 50nm but 150nm or less, × larger than ±150nm | | | | | | | |

EP 1 783 825 A1

Further, after ion etching is performed for single-crystal silicon carbide similarly as above, oxygen-containing nitrogen trifluoride mixed gas prepared by mixing oxygen gas with nitrogen trifluoride gas is used to perform DFE of single-crystal silicon carbide. This two-stage treatment of single-crystal is performed several times under different conditions in the embodiments 29 to 31, the comparative example 10, and the comparative example 11, the results of which are shown in Table 3.

[Table 3]

| | Crystal structure of silicon carbide obtained through reaction with nitrogen trifluoride gas which contains oxygen in the range of 10% to 20% | Down-flow etching (DFE) (a) | | Etching by Ar$^+$ ions (b) | | Repetition number of (a) and (b) | Smoothness note 3) |
|---|---|---|---|---|---|---|---|
| | | Nitrogen trifluoride Pressure (Pa) | RF power (W) | Pressure (Pa) | RF power (W) | | |
| Embodiment 29 | 4H | 53 | 100 | 3 | 150 | 40 | ◎ |
| Embodiment 30 | 6H | 53 | 100 | 3 | 150 | 40 | ◎ |
| Embodiment 31 | 3C | 53 | 100 | 3 | 150 | 40 | ◎ |
| Comparative example 10 | 4H | 53 | 100 | 3 | 150 | 35 | × |
| Comparative example 11 | 4H | 53 | 100 | 3 | 150 | 25 | × |
| Note 3): smoothness: ◎ within ±50nm, o larger than 50nm but 150nm or less, × larger than ±150nm | | | | | | | |

Next, an explanation will be made for the identification of chemical species in nitrogen trifluoride plasma, measurement of concentrations of the chemical species and measurement of etching rate. First, an explanation will be made for a method used for these measurements.

(Method for identifying chemical species in nitrogen trifluoride plasma and measuring the concentration of the chemical species)

The following emission spectroscopic analysis is conducted to identify chemical species in nitrogen trifluoride plasma and measure the concentration of the chemical species. Light emitted inside a chamber is collected from an observation window made with Pyrex (registered trade mark) by using a CCD camera and received by bundle fibers. The light is made incident into a diffraction grating of the computer-controlled spectrometer, intensified and detected by using a CCD element, which is converted to digital signals. Then, the signals are captured in the computer for monitoring. The spectrometer and related instruments used in this experiment include SPG-120PM, AT-120PM, AT-120PL, AT-100AP, AT-100PCC (made by Shimadzu Corporation). In this experiment, attention is focused on the spectra assigned to $N^+$ ion at 353.2nm and spectra assigned to fluorine radical at 703.7nm.

(Method for measuring etching rate)

A series of photolithography technologies are used to pattern an Al mask (99.99% made by Nilaco Corporation) on the surface of single-crystal silicon carbide. In order to measure the etching rate, the samples are submerged into a phosphoric acid solution ($H_3PO_4$ : $HNO_3$ : $CH_3COOH$ : $H_2O$= 8:3:1:1) approximately for 5 minutes after etching to dissolve and remove the Al mask from the surface of the samples. A step between the etched surface by the above treatment and the surface not etched by the Al masking treatment is measured by using a laser displacement meter (made by Keyence Corporation).

Since a 100nm or greater step which allows the measurement by a laser displacement meter is required in establishing an etching time, the etching time is established to be 10 minutes or longer. The etching rate referred to in the text or drawings is a value obtained by dividing the step measured after etching treatment with time etched. Further, the measurement is made at 1000 sites and expressed by their average value.

Next, an explanation will be made for the results and discussion on the above measurements.

(Results and discussion on the identification of chemical species and measurement of concentration of the chemical species)

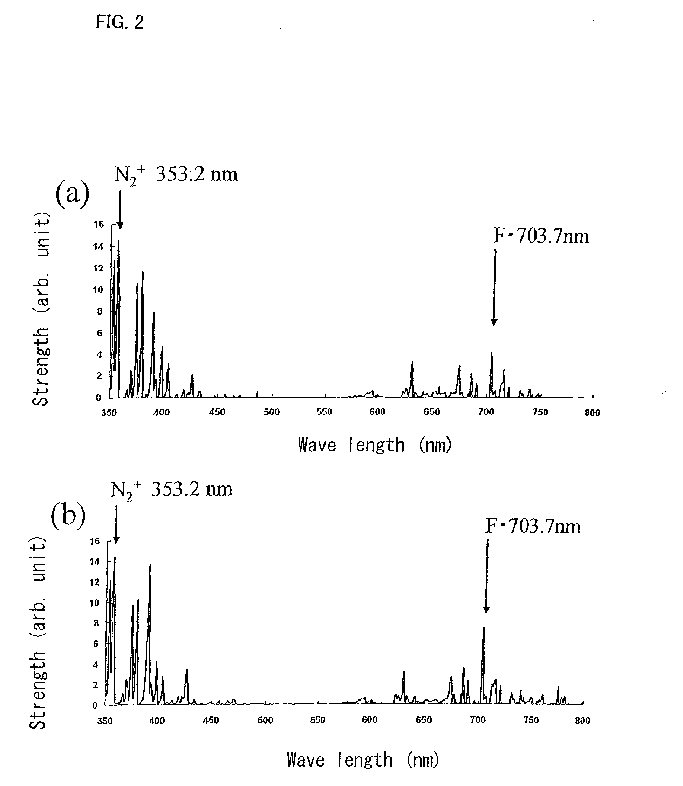

Results of emission spectroscopic analysis of nitrogen trifluoride plasma conducted under the conditions that the pressure of nitrogen trifluoride is 10Pa, the applied power is 100W and the flow rate of nitrogen trifluoride is 10sccm are shown in Fig. 2, where (a) indicates a result obtained by conducting an emission spectroscopic analysis in a state that samples are not placed in a chamber, and (b) indicates a result obtained by conducting the analysis in a state that the samples are placed. As apparent from Fig. 2, no peak is newly observed even if the samples are placed.

However, the radial strength of the fluorine radical (F·) is decreased when the samples are placed. Peaks assigned to a nitrogen system such as $N^+$ ion, $N_2^+$ ion and $N_2$ are observed in the vicinity from 350nm to 400nm, and peaks assigned to fluorine radicals are observed in the vicinity from 600nm to 750nm. Reactions of generating fluorine radicals and nitrogen ions in $NF_3$ plasma are shown as follows.

Further, $N_2^+$ ions and fluorine radicals are consumed in a great quantity on etching of silicon carbide, and their chemical species are mainly involved in etching of silicon carbide.

$$NF_3 \ \rightarrow \ NF_2 \cdot + \ F \cdot \qquad (1)$$

$$NF_2 \cdot \rightarrow \ NF \cdot + \ F \cdot \qquad (2)$$

$$NF \cdot \rightarrow \ N \cdot \ + \ F \cdot \qquad (3)$$

$$NF\cdot \rightarrow N^+ + F\cdot + e \qquad (4)$$

$$N\cdot \rightarrow N^+ + e \qquad (5)$$

$$2N\cdot \rightarrow N_2 \qquad (6)$$

$$N_2 \rightarrow N_2^+ + e \qquad (7)$$

Then, in measuring concentrations in this experiment, evaluation is made for the dependence of concentrations of chemical species on the etching rate in reactive ion etching of silicon carbide and on the spike formation by measuring the concentrations of $N_2^+$ ions and fluorine radicals, with attention focused on the peaks assigned to N+ ions at 353.2nm and peaks assigned to fluorine radicals at 703.7nm.

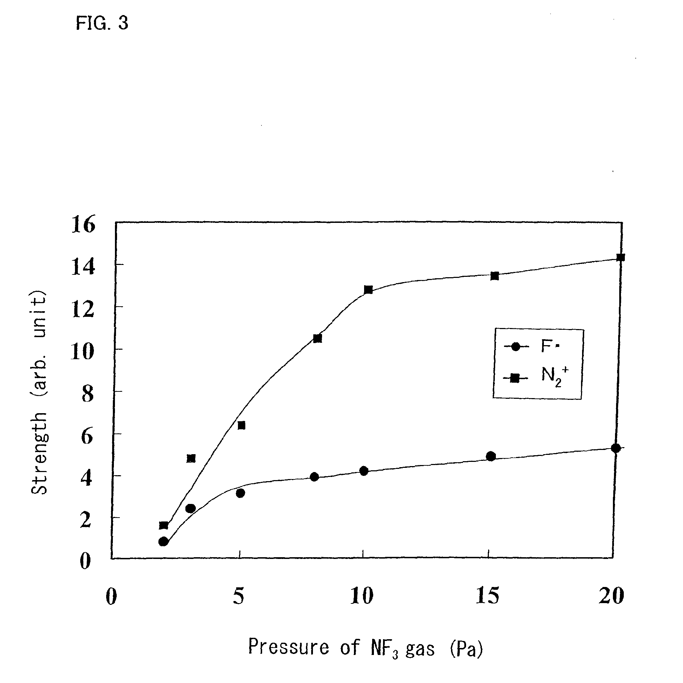

An emission spectroscopic analysis is to be initiated one minute and 30 seconds later after the induction of plasma. Further, since the peak strength is dependent on the number of particles, it is expressed as the concentration in this experiment. First, samples are placed inside a chamber, and evaluations are made for a change in peak strength of $N_2^+$ ions and fluorine radicals when the pressure of nitrogen trifluoride is allowed to change under the conditions that the applied power is 100W and the flow rate of nitrogen trifluoride is 10sccm, the results of which are shown in Fig. 3. Fluorine radicals are greatly increased in peak strength with an increase in pressure of nitrogen trifluoride from 2Pa to 5Pa and gradually increased in peak strength with an increase in pressure of nitrogen trifluoride over the range of 5Pa to 20Pa. Further, $N_2^+$ ions are greatly increased in peak strength in pressure up to 10Pa but gradually increased in peak strength with a further increase in pressure of nitrogen trifluoride. On the basis of these findings, it is clear that chemical species in plasma are also increased in concentration with an increase in pressure of nitrogen trifluoride.

(Results and discussion on measurement of etching rate)

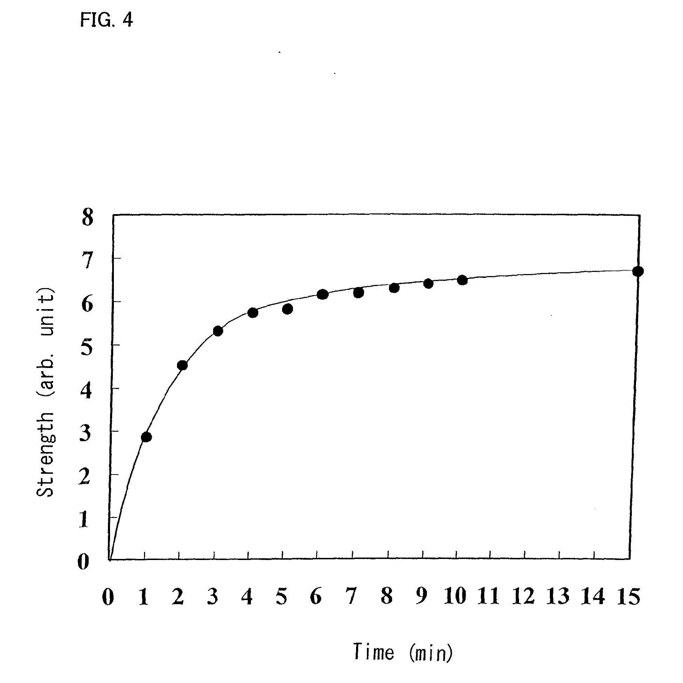

The peak strength assigned to fluorine radicals at 703. 7nm is evaluated for a change with the lapse of time with reference to nitrogen trifluoride plasma generated in a state that no silicon carbide is placed on a sample base under the conditions that the applied power is 100W, the pressure of nitrogen trifluoride is 10Pa and the flow rate of nitrogen trifluoride is 10sccm, the result of which is shown in Fig. 4. Fluorine radicals are increased in concentration approximately for 4 minutes after the induction of plasma but kept constant thereafter. Thus, the etching time is established to be 10 minutes, during which the dissociation of nitrogen trifluoride sufficiently proceeds and the depth of etching can be fully measured.

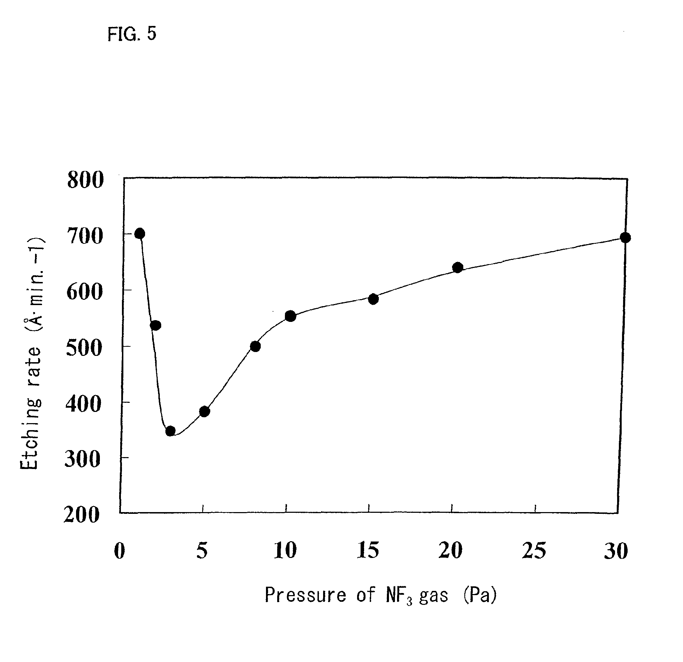

The pressure of nitrogen trifluoride is allowed to change from 2Pa to 30Pa to perform etching and the etching rate of silicon carbide is measured under the constant conditions that the applied power is 100W and the flow rate of nitrogen trifluoride is 10sccm, the result of which is shown in Fig. 5. As apparent from Fig. 5, the etching rate is increased monotonously with a decrease in pressure of nitrogen trifluoride when the pressure is lower than 2Pa and with an increase in pressure of nitrogen trifluoride when the pressure is higher than 3Pa.

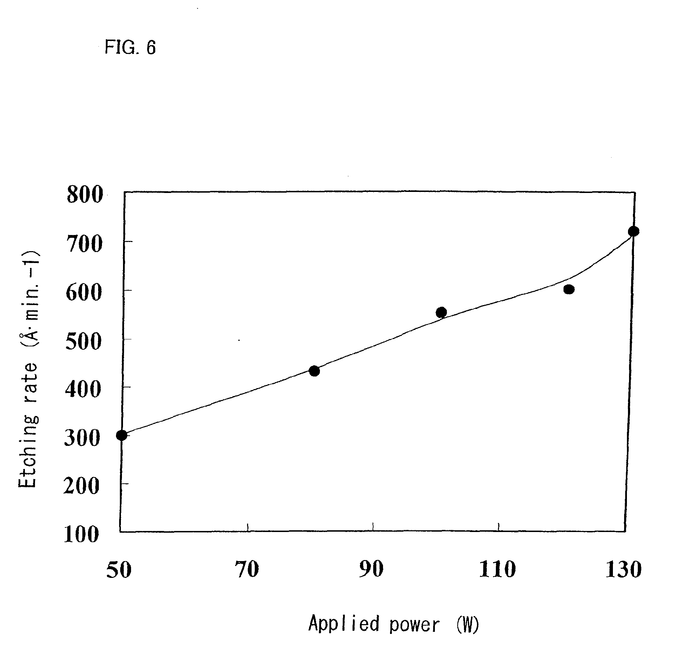

Next, the etching rate is measured when the applied power is allowed to change from 50W to 130W to perform etching under the constant conditions that the flow rate of nitrogen trifluoride is 10sccm and the pressure of nitrogen trifluoride is 10Pa, the result of which is shown in Fig. 6. In this instance, the pressure of nitrogen trifluoride is established to be 10Pa because observations are also made for a difference in spike formation depending on the applied power under the pressure of nitrogen trifluoride which allows spikes (needle-like projections) to form on the surface of silicon carbide. As apparent from Fig. 6, the etching rate is also increased with an increase in applied power.

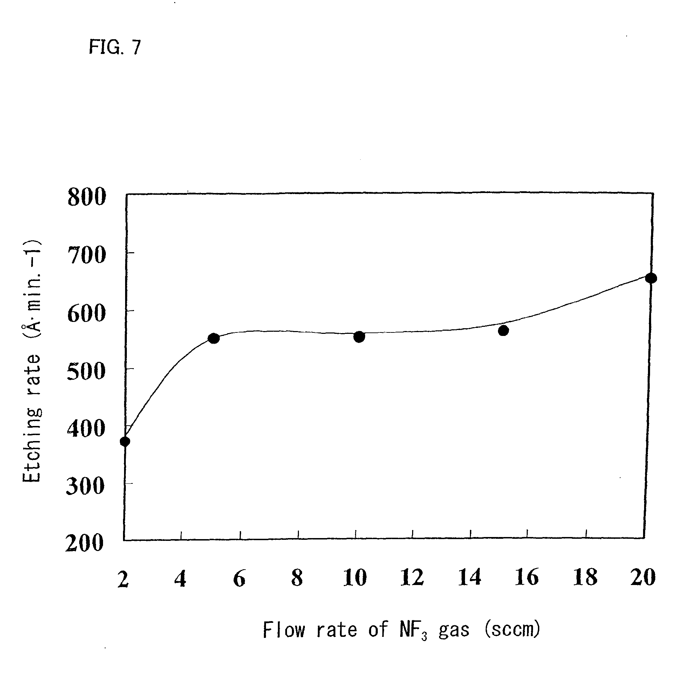

Next, the etching rate is measured when the flow rate of nitrogen trifluoride is allowed to change from 2sccm to 20sccm to perform etching under the constant conditions that the pressure of nitrogen trifluoride is 10Pa and the flow rate of nitrogen trifluoride is 10sccm, the result of which is shown in Fig. 7. The etching rate is also increased with an increase in the flow rate of nitrogen trifluoride until the flow rate is 5sccm but substantially kept constant in the range of 5sccm to 15sccm. Then, the etching rate is increased with an increase in flow rate of nitrogen trifluoride to 20sccm. The above-described tendency of the etching rate is well in conformity with an increasing tendency of fluorine radicals.

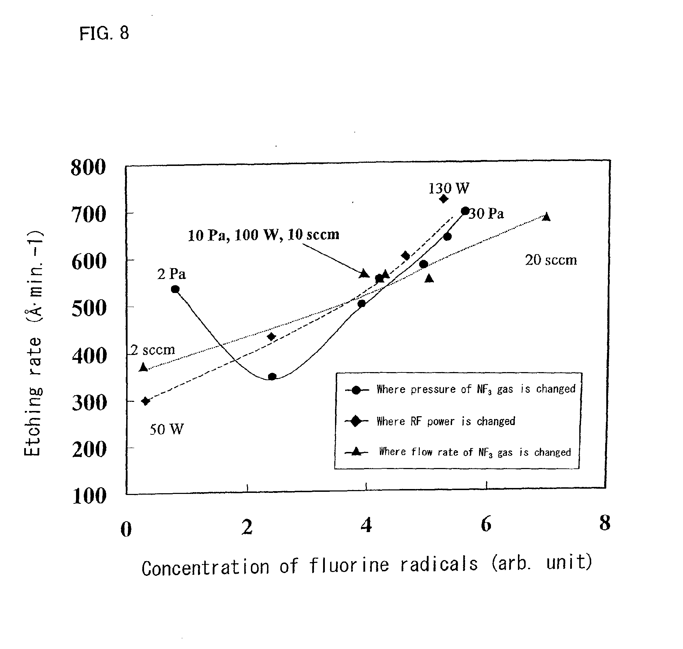

The relationship between the concentration of fluorine radicals and the etching rate is evaluated with respect to the change in pressure, change in applied power and change in flow rate, the results of which are summarized in Fig. 8. It is apparent from Fig. 8 that a high etching rate (536Å/min) is obtained with respect to a change in pressure under the pressure of nitrogen trifluoride of 2Pa, although the concentration of fluorine radicals is low. Except in a case where the pressure of nitrogen trifluoride is 2Pa, the etching rate is increased with an increase in concentration of fluorine radicals with respect to any change in pressure, applied power or flow rate of nitrogen trifluoride.

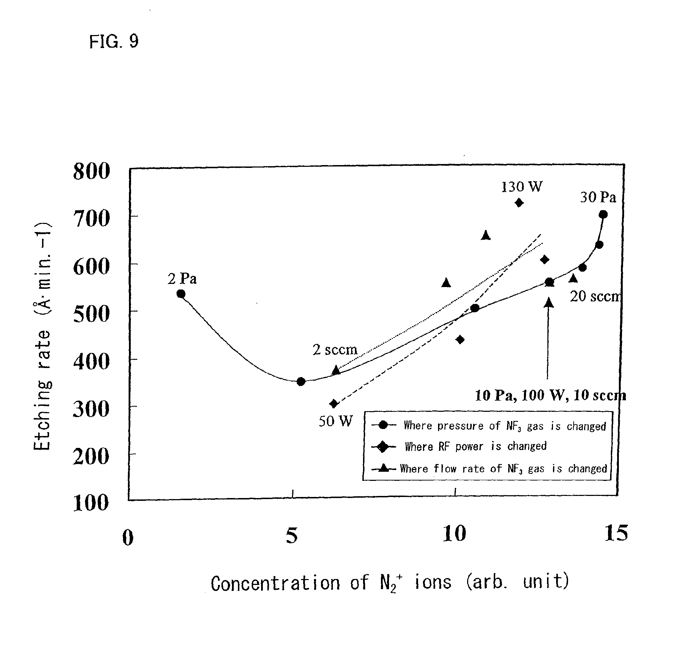

Fig. 9 shows the relationship between the concentration of $N_2^+$ ions and the etching rate which is not necessarily limited to the pressure of nitrogen trifluoride of 2Pa in a case of $N_2^+$ ions. The etching rate is also increased with an increase in the concentration of $N_2^+$ ions in the case of $N_2^+$ ions, which is not necessarily limited to the pressure of nitrogen trifluoride of 2Pa. Incidentally, not only in the case where the pressure of nitrogen trifluoride is 2Pa but also in the case where the applied power is 50W and the flow rate is 2sccm, the etching rate is great only in the case where the pressure of nitrogen trifluoride is 2Pa, although the concentrations of fluorine radicals and $N_2^+$ ions are low. Where the concentration of chemical species in plasma is low, a mean free pass of the chemical species is made long, the kinetic energy on collision of cations against silicon carbide is increased, which may result in an easy advance of physical energy. Therefore, a similar phenomenon should occur also in the case where the applied power is 50W and the flow rate is 2sccm. Since cations are accelerated depending on the strength of the electric field in an ion sheath, the applied power of 100W is required in obtaining a sufficient kinetic energy.

Where the pressure of nitrogen trifluoride is 2Pa, the mean free path of cations such as $N_2^+$ ions is increased due to a low concentration of chemical species in plasma. More specifically, a negative bias potential of the RF electrode may prolong a distance of cations to be accelerated and result in an increase in kinetic energy. Therefore, carbons hardly etched under the pressure of nitrogen trifluoride of 2Pa can be effectively removed by physical etching with cations due to a difference in binding energy with fluorine (binding energy : Si - F : 130kcal/mol, C - F: 107kcal/mol), thereby a smooth surface and a high etching rate are obtained.

On the other hand, where the pressure of nitrogen trifluoride is 10Pa, fluorine radicals are changed according to a change in applied power and flow rate, and the etching rate is increased with an increase in fluorine radicals. Since the carbon-rich silicon carbide surface is generated to form an innumerable number of spikes, an increased concentration of the chemical species in plasma reduces the mean free path of cations and fails in sufficiently obtaining kinetic energy. Then, carbon is ablated by cations at a reduced speed and, as a result, silicon may be preferentially etched by fluorine radicals.

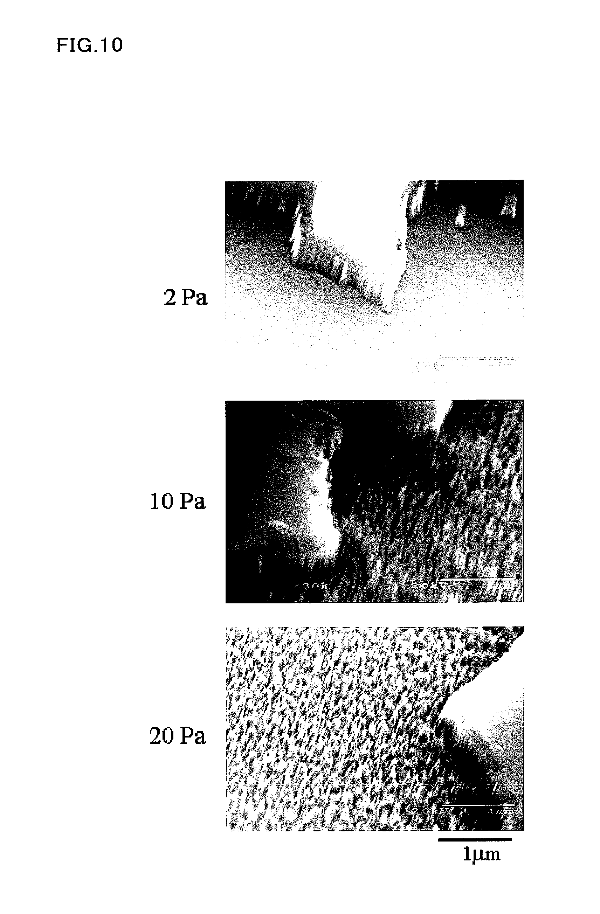

A scanning electron microscope (SEM) is used to photograph the surfaces of single-crystal silicon carbide samples etched for 10 minutes under the conditions that the applied power is 100W, the flow rate of nitrogen trifluoride is 10 (sccm) and the respective pressures of $NF_3$ gas of 2, 10 and 20Pa. The photos of the samples (SEM images) are respectively shown in Fig. 10. It is apparent from Fig. 10 that those etched under the conditions that the applied power is 100W, the flow rate of nitrogen trifluoride is 10 (sccm) and the pressure of nitrogen trifluoride is 2Pa are free of spikes on the surface of single-crystal silicon carbide samples. However, it is also apparent that spikes are formed on the etched surface where the pressure of nitrogen trifluoride is increased to 10Pa and 20Pa.

It is, therefore, apparent that the etching is performed by subjecting nitrogen trifluoride gas to plasma excitation, thereby single-crystal silicon carbide having an extremely smooth surface is obtained. Further, where the pressure of nitrogen trifluoride is 10Pa or more under the above-described etching conditions, spikes are formed on the etched surface. In this instance, however, it is also apparent that ion etching treatment by $Ar^+$ ion and down-flow etching treatment by nitrogen trifluoride are alternately repeated several times, thereby single-crystal silicon carbide having an extremely smooth surface is obtained.

Next, the etching rate of oxygen-containing nitrogen trifluoride mixed gas in plasma is measured, chemical species are identified and the concentration of the chemical species is measured. An explanation for their methods will be omitted here, because they are similar to those described above. In identifying the chemical species and measuring the concentration of the chemical species, $N_2^+$ ion, fluorine radical and oxygen radial are evaluated, with attention focused on the respective spectra of 353.2nm, 703.7nm and 777nm.

(Results and discussion on measurement of etching rate)

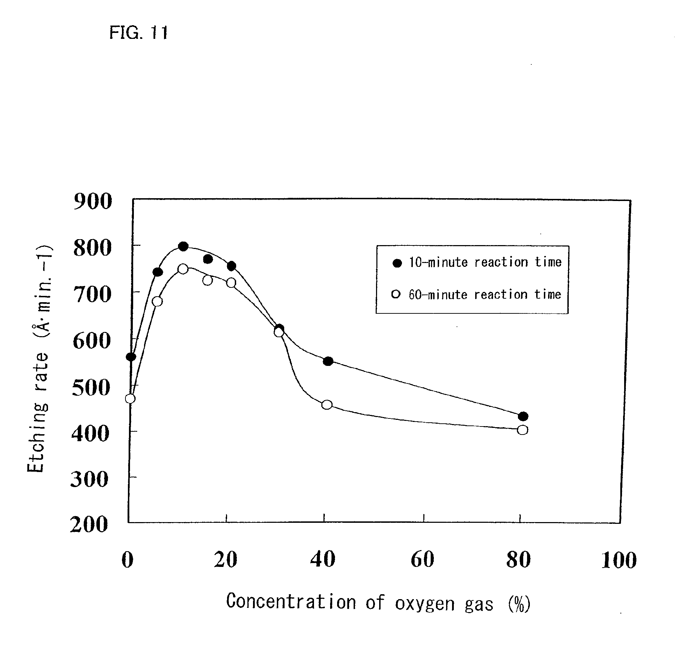

Samples are etched for 10 minutes and 60 minutes under the constant conditions that a total pressure is 10Pa, the applied power is 100W and a total flow rate is 10sccm, to evaluate the change in the etching rate in association with the change in the oxygen concentration, the results of which are shown in Fig. 11. In this instance, the total pressure is established to be 10Pa, because chemical etching is to mainly participate in reactions. As apparent from Fig. 11, as compared with samples etched for 10 minutes, those etched for 60 minutes exhibit a decrease in the etching rate of SiC at all oxygen concentrations. However, the etching rate is increased with an increase in oxygen concentration both for the samples etched for 10 minutes and those etched for 60 minutes, a maximum value is exhibited at the oxygen concentration of 10%. Further, the etching rate is monotonously decreased when the oxygen concentration is further increased.

(Results and discussion on identification of chemical species and measurement of concentration of the chemical species)

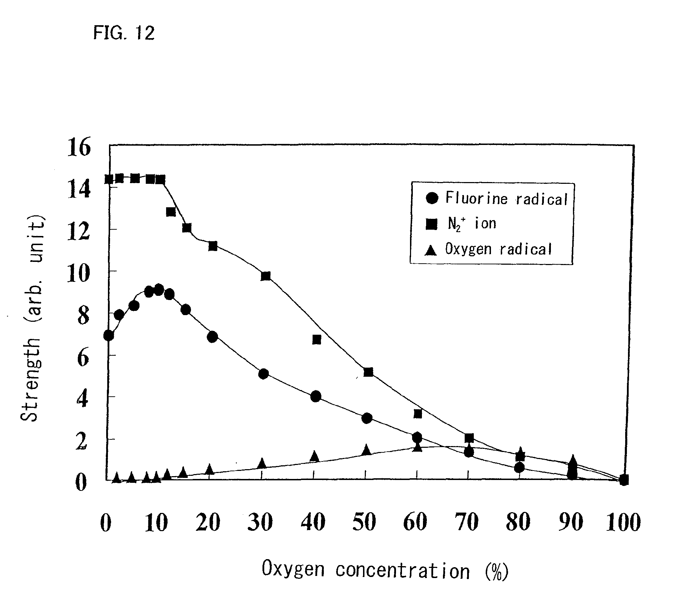

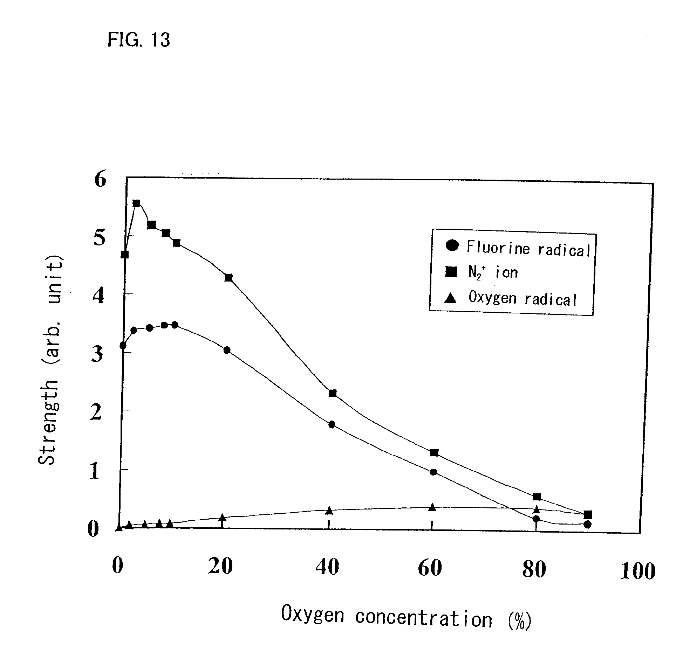

An emission spectroscopic analysis is conducted under the above-described conditions to evaluate the concentration of chemical species $NF_3/O_2$ plasma, the results of which are shown in Fig. 12. First, the concentration of fluorine radicals is increased with an increase in oxygen concentration, a maximum value is exhibited when oxygen is added at the concentration of 10%. The concentration of fluorine radicals is monotonously decreased with a further increase in oxygen concentration. In contrast, in measuring the concentration of $N_2^+$ ions, the peak strength exceeds an upper detection limit of the equipment where the oxygen concentration is in the range of 0% to 10%, and any concentration higher than the limit cannot be measured. As shown in Fig. 13, where the concentration of $N_2^+$ ions is measured under the pressure of $NF_3$ of 5Pa, the concentration is increased to a maximum level at the oxygen concentration of 2% and monotonously decreased with a further increase in oxygen concentration. Further, the concentration of fluorine radicals is increased to a maximum level at the oxygen concentration of 10% similar to the where the pressure of $NF_3$ is 10Pa. On the basis of the above findings, the concentration of $N_2^+$ ions measured under the pressure of $NF_3$ of 10Pa is considered to be similar in tendency to that measured under the pressure of $NF_3$ of 5Pa. Finally, the concentration of oxygen radicals is gradually increased at the oxygen concentration of up to 60% and gradually decreased with a further increase in oxygen concentration. As a result, the etching rate of SiC is considered to increase with an increase in fluorine radicals resulting from the addition of oxygen. However, where the oxygen concentration is in the range of 20% to 30%, the etching rate is greatly increased more than a case of $NF_3$ plasma alone, although the concentration of fluorine radicals is lower.

Since fluorine radicals are high in surface charge density and electrostatic repulsion is also great between fluorine atoms, attack by fluorine radicals is less likely to occur at a part where C-F couplings are formed to some extent on the surface of SiC. On the other hand, in view of the fact that oxygen radicals are also high in surface charge density but an oxygen/carbon binding energy is greater than a fluorine/carbon binding energy, carbons at a site abundant in C-F couplings are also exposed to attack by oxygen radicals to cause reactions between oxygen radicals and carbons, and easily removed as $CO_x$. As a result, it is estimated that the etching rate is increased and formation of spikes is inhibited in $NF_3/O_2$ plasma. More specifically, it is understood that due to addition of oxygen, not only are fluorine radicals increasedbut also oxygen radicals are allowed to react with a part of carbon in SiC and removed as $CO_x$, the etching rate of SiC is greatly influenced. These findings clearly exhibit that oxygen-containing nitrogen trifluoride mixed gas is subjected to plasma excitation to perform etching, thereby it makes it possible to obtain single-crystal silicon carbide having an extremely smooth surface. It is also apparent that even if an etched surface is in a spike form, etching treatment by $Ar^+$ ions and down-flow etching treatment by nitrogen trifluoride are repeatedly provided to the surface alternately several times, thereby it makes it possible to obtain single-crystal silicon carbide having an extremely smooth surface.

Brief Description of the Drawings

Fig. 1 is a drawing briefly showing a plasma chamber used in the present invention;
Fig. 2 shows the results of emission spectroscopic analysis for nitrogen trifluoride plasma conducted under the conditions that the applied power is 100W and the flow rate of nitrogen trifluoride is 10sccm, where (a) is a graph where no sample is placed and (b) is a graph where samples are placed;
Fig. 3 is a graph showing the change in peak strength of $N_2^+$ ions and fluorine radicals when the pressure of nitrogen trifluoride is allowed to change under the conditions that the applied power is 100W, the flow rate of nitrogen trifluoride is 10sccm and the reaction time is 10 minutes;
Fig. 4 is a graph showing the result obtained by evaluating the change with the lapse of time in peak strength assigned to fluorine radicals at 703.7nm in nitrogen trifluoride plasma generated in a state that no silicon carbide is placed on a sample base under the conditions that the applied power is 100W, the pressure of nitrogen trifluoride is 10Pa and the flow rate of nitrogen trifluoride is 10sccm;
Fig. 5 is a graph showing the result obtained by measuring the etching rate of silicon carbide when the pressure of nitrogen trifluoride is changed from 2Pa to 30Pa to perform etching under constant conditions that the applied power is 100W, the flow rate of nitrogen trifluoride is 10sccm and the reaction time is 10 minutes;
Fig. 6 is a graph showing the etching rate obtained when the applied power is changed from 50W to 130W to perform etching under constant conditions that the flow rate of nitrogen trifluoride is 10sccm, the pressure of nitrogen trifluoride is 10Pa and the reaction time is 10 minutes;
Fig. 7 is a graph showing the result obtained by measuring the etching rate of silicon carbide when the pressure of nitrogen trifluoride is changed from 2Pa to 30Pa to perform etching under constant conditions that the applied power is 100W, the flow rate of nitrogen trifluoride is 10sccm and the reaction time is 10 minutes;
Fig. 8 is a graph showing the relationship between the concentration of fluorine radicals and the etching rate with reference to a change in pressure, change in applied power and change in flow rate;

Fig. 9 is a graph showing the relationship between the concentration of $N_2^+$ ion and the etching rate;

Fig. 10 shows SEM images of sample surfaces photographed after etching is performed for 10 minutes under the pressure of nitrogen trifluoride of 2Pa, 10Pa or 20Pa;

Fig. 11 is a graph showing the change in the etching rate according to the change in oxygen concentration observed when etching is performed for 10 minutes and 60 minutes under constant conditions that a total pressure is 10Pa, the applied power is 100W and a total flow rate is 10sccm;

Fig. 12 is a graph showing the results obtained by evaluating the concentration of chemical species in $NF_3/O_2$ plasma on the basis of emission spectroscopic analysis under constant conditions that a total pressure is 10Pa, the applied power is 100W and a total flow rate is 10sccm; and

Fig. 13 is a graph showing the results obtained by evaluating the concentration of chemical species in $NF_3/O_2$ plasma on the basis of emission spectroscopic analysis under constant conditions that a total pressure is 5Pa, the applied power is 100W and a total flow rate is 10sccm.

Description of Symbols

| 1: | Gas feeding port |
|---|---|
| 2: | Grounding electrode |
| 3: | Sample |
| 4: | RF electrode |
| 5: | CCD camera |
| 6: | Flow controller |
| 7: | Chamber body |
| 8: | Valve |
| 9: | Flow meter |
| 10: | Storage tank of argon gas |
| 10: | Storage tank of oxygen gas |
| 12: | Storage tank of nitrogen gas |
| 13: | Storage tank of nitrogen trifluoride gas |

**Claims**

1. Single-crystal silicon carbide in which smoothness observed by an atomic force microscope is within $\pm$ 150nm.

2. An etching method for single-crystal silicon carbide, wherein nitrogen trifluoride gas is subjected to plasma excitation to treat the surface of single-crystal silicon carbide.

3. The etching method for single-crystal silicon carbide according to Claim 2, wherein the pressure of nitrogen trifluoride gas is in the range of 0.5 to 10Pa.

4. The etching method for single-crystal silicon carbide according to Claim 2, wherein the flow rate of nitrogen trifluoride gas is in the range of 5 to 15sccm.

5. The etching method for single-crystal silicon carbide according to Claim 2, wherein the applied power is in the range of 50 to 100W when nitrogen trifluoride gas is subjected to plasma excitation.

6. The etching method for single-crystal silicon carbide according to Claim 2, wherein ion etching by rare gas radicals and down-flow etching by nitrogen trifluoride gas are repeated as additional treatment to obtain a smooth surface.

7. An etching method for single-crystal silicon carbide, wherein oxygen gas-containing nitrogen trifluoride gas is subjected to plasma excitation to treat the surface of single-crystal silicon carbide.

8. An etching method for single-crystal e silicon carbide comprising a step in which oxygen gas-containing nitrogen trifluoride gas is subjected to plasma excitation to treat the surface of single-crystal silicon carbide, and a step in which ion etching by rare gas radicals and down-flow etching by nitrogen trifluoride gas are repeated as additional treatment to obtain a smooth surface.

9. The etching method for single-crystal silicon carbide according to Claim 2, Claim 7 or Claim 8, wherein the above-described single-crystal silicon carbide is selected from 3C type, 4H type or 6H type.

FIG. 1

FIG. 2

(a) $N_2^+$ 353.2 nm — F·703.7nm

(b) $N_2^+$ 353.2 nm — F·703.7nm

FIG. 3

FIG. 4

FIG. 5

FIG. 6

FIG. 7

FIG. 8

FIG. 9

FIG.10

2 Pa

10 Pa

20 Pa

1μm

FIG. 11

FIG. 12

FIG. 13

### INTERNATIONAL SEARCH REPORT

| | International application No. |
|---|---|
| | PCT/JP2005/012473 |

A. CLASSIFICATION OF SUBJECT MATTER
   Int.Cl⁷ H01L21/3065, C30B29/36, 33/08

According to International Patent Classification (IPC) or to both national classification and IPC

B. FIELDS SEARCHED

Minimum documentation searched (classification system followed by classification symbols)
   Int.Cl⁷ H01L21/3065, C30B29/36, 33/08

Documentation searched other than minimum documentation to the extent that such documents are included in the fields searched
   Jitsuyo Shinan Koho          1922-1996  Jitsuyo Shinan Toroku Koho   1996-2005
   Kokai Jitsuyo Shinan Koho    1971-2005  Toroku Jitsuyo Shinan Koho   1994-2005

Electronic data base consulted during the international search (name of data base and, where practicable, search terms used)
   JOIS

C. DOCUMENTS CONSIDERED TO BE RELEVANT

| Category* | Citation of document, with indication, where appropriate, of the relevant passages | Relevant to claim No. |
|---|---|---|
| X<br>Y | A. TASAKA et al., 'Plasma etching of SiC sueface using NF3' Journal of Vacuum Science and Tehcnology, A, Vol.20, No.4, July, August 2002, pages 1254 to 1260 | 1-6,9<br>8 |
| X<br>Y | Eiji WATANABE, Akimasa TASAKA, 'NF3/02 Plasma o Mochiita SiC no Heikatsu eching', 2003 Nen, The Electrochemical Society of Japan Taikai Koen Yoshishu, 70ᵗʰ, page 198 | 2-5,7<br>8 |
| X | HYU-JOON CHOI and BYUNG-TEAK LEE., 'Inductively Coupled Plasma Reactive Ion Etching of SiC Single Crystals Using NF3-Based Gas Mixtures', Journal of ELECTRONIC MATERIALS, Vol.32, No.1, 2003, pages 1 to 4 | 2-5,7,9 |

☒ Further documents are listed in the continuation of Box C. ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 05 September, 2005 (05.09.05) | 20 September, 2005 (20.09.05) |

| Name and mailing address of the ISA/ | Authorized officer |
|---|---|
| Japanese Patent Office | |
| Facsimile No. | Telephone No. |

Form PCT/ISA/210 (second sheet) (January 2004)

**INTERNATIONAL SEARCH REPORT**

| International application No. |
| --- |
| PCT/JP2005/012473 |

C (Continuation).    DOCUMENTS CONSIDERED TO BE RELEVANT

| Category* | Citation of document, with indication, where appropriate, of the relevant passages | Relevant to claim No. |
| --- | --- | --- |
| X | JP 7-161690 A  (Toshiba Corp.),<br>23 June, 1995 (23.06.95),<br>Par. Nos. [0010] to [0018]<br>(Family: none) | 2-5,7 |

Form PCT/ISA/210 (continuation of second sheet) (January 2004)

# EP 1 783 825 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **P.H.YIHA ; J. STECKEL.** *J. Electrochem. Soc.,* 1993, vol. 140, 1813
- **J. SUGIURA ; W. J. LU ; K. C. CADIEN ; A. J. STECKEL.** *J. Vac. Sci. Technol.,* 1986, vol. B4, 349
- **J. W. PALMOUR ; R. F. DAVIS ; T. M. WALLET ; K. B. BHASM.** *J. Vac. Sci. Technol.,* 1986, vol. A4, 590
- **G. KELNER ; S. C. BINARI ; P. H. KLEIN.** *J. Electrochem. Soc.,* 1990, vol. 137, 213
- **J. W. PALMOUR ; R. F. DAVIS ; P. ASTELL-BURT ; P. BLACKBOROW.** *Mater. Res. Soc. Symp. Proc.,* 1987, vol. 76, 185
- **W.-S. PAN ; A. J. STECKEL.** *J. Electrochem. Soc.,* 1990, vol. 137, 213
- **R. PADIYATH ; R. L. WRIGHT ; M. I. CAUDHRY ; S. V. BABU.** *Appl. Phys. Lett.,* 1991, vol. 58, 1053
- **WANG J. J ; LAMBERS E. S. ; PEARTON S. J. ; OSTLING M. ; ZETTERLING C. M. ; GROW J. M. ; REN F. ; SHUL R. J.** *Vac. Sci. Technol.,* vol. A16, 2204
- **G. KELNER ; S. C. BINARI ; P. H. KLEN.** *J. Electrochem. Soc.,* 1987, vol. 134, 253